# FASCICULE DE BREVET EUROPEEN

(11) **EP 3 538 479 B1**
(45) Date de publication et mention de la délivrance du brevet: **30.03.2022**
(21) Numéro de dépôt: 17816994.2
(22) Date de dépôt: 06.12.2017
(51) Int. Cl.: B81B 3/00

(54) **DISPOSITIF DE TRANSMISSION D'UN MOUVEMENT ET D'UNE FORCE ENTRE DEUX ZONES ISOLÉES L'UNE DE L'AUTRE**
VORRICHTUNG ZUR ÜBERTRAGUNG EINER BEWEGUNG UND EINER KRAFT ZWISCHEN ZWEI VONEINANDER ISOLIERTEN ZONEN
DEVICE FOR TRANSMITTING A MOVEMENT AND A FORCE BETWEEN TWO ZONES THAT ARE INSULATED FROM ONE ANOTHER

(30) Priorité: 07.12.2016 FR 1662049
(43) Date de publication de la demande: 18.09.2019
(73) Titulaire: Commissariat à l'énergie atomique et aux énergies alternatives, 75015 Paris (FR)
(72) Inventeur: JOET, Loïc, 38640 Claix (FR)
(74) Mandataire: Brevalex
(86) Numéro de dépôt international: PCT/FR2017/053409
(87) Numéro de publication internationale: WO 2018/104656

(56) Documents cités:
- EP-A1- 2 921 836

## Description

### DOMAINE TECHNIQUE ET ÉTAT DE LA TECHNIQUE ANTÉRIEURE

La présente invention se rapporte à un dispositif de transmission d'un mouvement et d'une force entre deux zones séparées l'une de l'autre de manière étanche dans le domaine de la microélectronique et notamment celui des micro-dispositifs de type microsystèmes électromécaniques (MEMS pour Microelectromechanical systems en terminologie anglo-saxonne)) et/ou nanosystèmes électromécaniques (NEMS pour Nanoelectromechanical systems en terminologie anglo-saxonne) Un tel dispositif peut par exemple être mis en œuvre dans un dispositif de mesure d'une variation de pression, par exemple pour réaliser un microphone ou dans un capteur de pression.

Les microphones en microélectromécanique et/ou en nanoélectromécanique représentent un marché en pleine expansion, notamment grâce au marché des appareils nomades, tels que les tablettes, les téléphonées portables type smartphone et autres objets connectés, dans lesquels ils replacent peu à peu les microphones à électret.

Les microphones mesurent une variation de pression, ils comportent donc au moins une partie en contact avec l'extérieur.

La plupart des microphones MEMS actuellement produits sont des microphones à détection capacitive, dont un exemple de réalisation est décrit dans le document A. Dehe : Silicon microphone development and application, (2007) Sensors and Actuators, A: Physical, 133 (2 SPEC. ISS.), pp. 283-287*.*

Par exemple ils comportent une membrane souple séparant l'extérieur d'une chambre fermée, dite volume arrière, servant de référence de pression. La membrane se déforme sous l'effet du différentiel de pression entre ses deux faces. La membrane forme une électrode et une contre-électrode fixe et rigide est disposée en regard de la membrane. La membrane et la contre électrode forment une capacité dont la valeur varie en fonction de la déformation de la membrane sous l'effet du différentiel de pression entre ses deux surfaces.

Des trous dans la membrane, dit trous de ventilation, assurent l'égalisation des pressions entre l'extérieur et le volume arrière du microphone. Ainsi, les dérives à long terme de la pression atmosphérique, par exemple dues à la variation d'altitude, à un anticyclone ou une dépression, dont l'amplitude est de plusieurs ordres de grandeur au-dessus de celle du son, n'ont pas d'action sur la membrane car elles s'égalisent de chaque côté de celle-ci. Les trous sont dimensionnés pour que cette annulation ne s'applique qu'à des faibles fréquences, typiquement entre 1 et 100Hz, pour ne pas filtrer les fréquences audibles.

La contre-électrode est également percée de trous et laisse passer l'air afin que la pression puisse s'établir sur la surface de la membrane

Cette structure offre un certain nombre d'avantages, cependant elles présentent des inconvénients notamment dus à la présence de la contre-électrode. En effet, celle-ci se trouve dans le chemin acoustique. Bien que trouée, elle présente une résistance acoustique, i.e. elle offre une résistance au passage de l'air, et donc à l'établissement de la pression. Cette résistance engendre du bruit thermique, et donc une dégradation du seuil de détection. Elle engendre aussi de l'amortissement, ce qui implique une réduction de la bande passante du microphone.

Pour limiter cette résistance, la surface de la contre-électrode couverte par des trous peut être augmentée, mais ceci a pour conséquence directe la réduction des surfaces en regard, ce qui réduit proportionnellement la détection capacitive. Ainsi le gain de la transduction est réduit et le bruit de la partie électronique est moins masqué, entrainant là aussi une dégradation du seuil de détection.

Un compromis est alors à trouver pour minimiser la dégradation globale du seuil de détection, notamment dû à la résistance acoustique et au bruit de l'électronique, tout en respectant la bande passante voulue.

On peut prévoir d'augmenter la surface de la membrane et de la contre-électrode pour augmenter la surface en regard. Mais une telle augmentation a pour effet d'augmenter la taille de la puce et donc son coût. En outre, une membrane de plus grande surface va déplacer plus d'air en se déformant. Ce volume d'air déplacé crée une augmentation/diminution de la pression dans la cavité arrière, imposant alors une force opposée au mouvement sur la membrane. Cette force est proportionnelle au ratio du carrée de la surface de membrane, sur le volume arrière. Cette force agit comme un ressort supplémentaire sur la membrane, qui va s'opposer au déplacement. L'augmentation de la surface de la membrane devra donc être accompagnée par une augmentation de la taille du volume arrière, et donc du boitier si l'on veut maintenir un déplacement de la membrane équivalent.

Il existe des microphones MEMS à détection piézo-électrique afin de supprimer les inconvénients résultant de la contre-électrode. Par exemple, la membrane comporte un matériau piézo-électrique. Lors de sa déformation, des charges sont créées à la surface du matériau piézo-électrique et sont collectées par les électrodes encapsulant ce matériau. Le signal électrique est représentatif du nombre de charges créées. Dans le cas de la détection piézo-électrique, le nombre de charges est donné par les contraintes mécaniques au cœur du matériau, il ne peut pas être augmenté grâce à une tension de polarisation ou tout autre artéfact externe. Si l'on souhaite obtenir plus de charges, il faudra augmenter la taille de la membrane pour récolter plus d'énergie, afin de contraindre plus le matériau piézo-électrique. Au contraire, dans le cas d'une détection capacitive, le nombre de charges créées est le produit de la variation de la capacité par la tension de polarisation. On peut donc collecter plus de charges en utilisant des tensions de polarisation plus élevées.

En outre, comme lors de la détection capacitive, une augmentation de la surface de la membrane impose une augmentation du volume arrière afin d'éviter l'augmentation de la raideur acoustique.

Par conséquent, un microphone à détection piézo-électrique offre un gain limité par rapport à celui de la détection capacitive. En outre, l'électronique associée est plus complexe à concevoir, car elle doit traiter un signal plus faible. Elle consomme donc plus de courant car elle doit présenter un bruit plus faible. Le gain de performances au niveau acoustique se paie alors dans le domaine électrique.

Le document EP2 921 836 divulgue un capteur de mesure de pression différentielle comprenant une chambre unique et fermée par des portions de membrane permettant ainsi au système d'être soumis à deux pressions différentes.

Le document US 2015/0251899 A1 décrit un capteur dans lequel la contre-électrode est disposée à l'intérieur de la membrane dans une atmosphère contrôlée qui peut être proche du vide. Le déplacement relatif de la membrane et de la contre-électrode n'entraîne pas de déplacement d'air à travers la contre-électrode. Du fait de son placement dans le vide, la contre-électrode est complètement masquée du monde acoustique.

Cependant la réalisation d'une telle structure est très complexe, notamment la libération de la contre électrode et la réalisation de l'étanchéité du volume dans lequel la contre-électrode est destinée à être isolée.

Il semble en outre difficile de réaliser une structure suffisamment légère pour conserver une grande bande passante, malgré la structure de la surface déformable et des nombreux piliers mis en œuvre à l'intérieur de celle-ci.

En outre, les piliers doivent, à la fois, être nombreux pour permettre à la membrane de tenir le vide, et laisser assez de surface pour placer la contre-électrode.

De manière générale il est souhaitable de pouvoir transmettre un mouvement et une force entre deux zones isolées l'une de l'autre de manière étanche, par exemple, lorsque l'on souhaite disposer des moyens de détection capacitifs dans une atmosphère contrôlée ou lorsque l'une des zones est un environnement agressif et l'autre zone doit être protégée de cet environnement agressif.

Par exemple, la transmission d'une force à une atmosphère à pression fortement réduite permet :
- de mettre en œuvre une détection par poutre vibrante avec un coefficient de qualité élevé.
- de mettre en œuvre une détection capacitive à frottement visqueux (et bruit Newtonien associé) réduit.
- de mettre en œuvre un moteur capacitif dont les frottements visqueux opposés aux mouvements sont fortement réduits, notamment lors de la réalisation d'un émetteur sonore ou ultrasonore.

Le document EP 2 921 836 décrit un capteur de mesure de pression différentielle comportant une première membrane soumise à une première pression sur une face et une pression de référence sur une autre face, une deuxième membrane soumise à une deuxième pression sur une face et à la pression de référence sur une autre face. Une poutre relie les deux membranes du côté des faces soumises à la pression de référence, la poutre étant articulée sur un support par une liaison pivot, et des moyens de mesure sensibles au déplacement de la poutre provoqué par la différence des pressions vues par les deux membranes.

### EXPOSÉ DE L'INVENTION

C'est par conséquent un but de la présente invention d'offrir un dispositif de transmission d'un mouvement et d'une force entre deux zones isolées l'une de l'autre de manière étanche, les deux zones étant à des pressions différentes.

Le but de la présente invention est atteint par un dispositif de transmission d'une force et d'un mouvements entre deux zones isolées de manière étanche l'une de l'autre, ledit dispositif comportant un support s'étendant dans un plan, au moins l'une des zones étant située d'un côté du plan, un élément de transmission s'étendant entre la première zone et la deuxième zone, une articulation pivot par laquelle l'élément de transmission est articulé en rotation par rapport au support et des moyens d'isolation étanche entre l'élément de transmission et le support au niveau de l'articulation pivot, de sorte qu'une force et un mouvement appliqués à l'élément de transmission dans l'une des première et deuxième zones sont transmis dans l'autre des deuxième ou première zones tout en assurant l'isolation étanche entre les deux zones.

Les moyens d'isolation étanche sont aptes à se déformer élastiquement de sorte à peu ou pas gêner la rotation de l'élément de transmission. Les moyens d'isolation étanche comportent avantageusement une membrane. Cette membrane peut être prévue très fine pour offrir une faible résistance au déplacement de l'élément de transmission et des renforts peuvent être prévus sur la membrane pour permettre à celle-ci, par exemple de tenir une différence de pression.

L'élément de transmission ayant un mouvement de rotation, ses mouvements de translation hors-plan sont sensiblement réduits, voire annulés. Avantageusement l'articulation en rotation est réalisée par des bras déformables en torsion qui limitent de manière importante, voire empêchent le déplacement en translation dans une direction hors-plan de l'élément de transmission. La transmission d'énergie dans les mouvements hors le mouvement de rotation dans la transmission est alors réduite. En utilisant des bras déformables présentant une section rectangulaire dont la dimension hors plan est fortement supérieure à la dimension dans le plan, on peut obtenir une articulation en rotation présentant une faible raideur angulaire, et donc de très faibles pertes d'énergie lors du mouvement de rotation. En outre, les mouvements dans le plan sont limités, voire annulés, par les moyens d'isolation étanche. Le rendement mécanique du dispositif de transmission est donc élevé.

De manière avantageuse, l'une des zones peut être une chambre à atmosphère contrôlée, avantageusement au vide, dans laquelle sont disposés des moyens de mesure capacitifs du mouvement transmis par l'élément de transmission, et/ou des moteurs capacitifs créant une force à transmettre par l'élément de transmission. Ces moyens capacitifs peuvent alors présenter de grande surface d'électrode sans que le frottement visqueux ne s'oppose au déplacement d'une partie desdits moyens capacitifs.

En outre, du fait de l'annulation des mouvements hors-plan, dans le cas d'un microphone, l'effet de la pression atmosphérique sur la mesure des moyens capacitifs est alors sensiblement réduit, voire annulé. Le dispositif mesure donc uniquement ou presque uniquement la variation de pression acoustique.

En outre, le dispositif peut être conçu pour offrir une amplification. En effet, en éloignant les moyens capacitifs de l'articulation en rotation, i.e. en réalisation un bras de transmission plus long, à rotation de l'élément de transmission donnée, le mouvement des moyens capacitifs est plus grand. Dans le cas de moyens de mesure, le signal recueilli est plus grand. Dans le cas du moteur, le couple transmis est plus grand.

Le dispositif peut être mis en œuvre dans un microphone, un capteur de pression différentiel statique ou dynamique.

Dans le cas d'un microphone, la première extrémité longitudinale de l'élément de transmission est par exemple solidaire d'une membrane présentant une grande surface soumise à la variation de pression, qui transmet à l'élément de transmission les variations de pression à haute fréquence, correspondant au signal acoustique. Des moyens de mesure du mouvement du bras de transmission sont situés au niveau de la deuxième extrémité du bras de transmission, par exemple des moyens de détection capacitif ou une poutre vibrante.

Dans le cas d'un haut-parleur, un actionneur, par exemple de type capacitif, peut être prévu à une extrémité de l'élément de transmission et appliqué à la membrane solidaire de l'autre extrémité de l'élément de transmission.

La présente invention a alors pour objet un dispositif, pour système microélectromécanique, de transmission d'un mouvement et d'une force entre une première zone et une deuxième zone isolées l'une de l'autre de manière étanche, ledit dispositif comportant un support s'étendant dans un plan, un élément de transmission mobile en rotation par rapport au support au moyen d'une articulation pivot d'axe de rotation parallèle au plan du support, une ouverture dans le support traversée par l'élément de transmission et au niveau de laquelle est disposée l'articulation pivot, l'élément de transmission comportant au moins un premier bras de transmission d'un côté du plan du support dans une des première et deuxième zones et un deuxième bras de transmission de l'autre côté du plan du support dans l'autre desdites première et deuxième zones, et des moyens d'isolation étanche disposés dans l'ouverture, tels qu'ils isolent de manière étanche la première zone de la deuxième zone et qu'ils permettent le mouvement de rotation de l'élément de transmission.

De préférence, les moyens d'isolation étanche comportent une membrane déformable élastiquement et tendue entre un rebord de l'ouverture et l'élément de transmission. Les moyens d'isolation étanche peuvent comporter des renforts mécaniques sur au moins une des faces de la membrane.

L'articulation pivot comporte avantageusement une lame ou plusieurs lames alignées s'étendant entre l'élément de transmission et un bord de l'ouverture et aptes à se déformer en torsion. La ou les lames présentent avantageusement une dimension selon une direction orthogonale au plan du support telle qu'elles offrent une rigidité dans la direction hors-plan limitant les mouvements hors-plan de l'élément de transmission.

Dans un exemple de réalisation, l'élément de transmission comporte au moins un arbre de transmission connectant les premier et deuxième bras de transmission, ledit arbre de transmission s'étendant dans une direction orthogonale au plan du support de part et d'autre des moyens d'isolation étanche. La ou les lames peuvent être connectées à l'arbre de transmission, et l'ensemble formé par l'arbre de transmission et les premier et deuxième bras de transmission peuvent être un ensemble rigide.

Dans un autre exemple de réalisation, l'élément de transmission comporte plusieurs arbres de transmission aptes à se déplacer en translation le long d'une direction orthogonale au plan du support. Chaque premier et deuxième bras de transmission est par exemple articulé sur chaque arbre de transmission par une articulation permettant une rotation et une translation. La ou les lames sont par exemple connectées mécaniquement à l'un des premier et deuxième bras de transmission. Pour chaque arbre de transmission, l'articulation permettant une rotation et une translation dudit arbre peut comporter une ou plusieurs lames de couplage.

L'une au moins des première et deuxième zones peut former une chambre sous atmosphère contrôlée.

Le dispositif de transmission peut comporter un élément mobile vis-à-vis du support tel qu'un piston ou une membrane apte à appliquer un mouvement et une force à l'élément de transmission dans la première zone.

De manière avantageuse, le dispositif de transmission comporte, dans la deuxième zone, des moyens de mesure du mouvement de et/ou de la force appliquée à l'élément de transmission dans la première zone et/ou des moyens d'actionnement. Par exemple, le dispositif de transmission comporte, dans la deuxième zone, une électrode solidaire de l'élément de transmission et au moins une contre-électrode formant des moyens de mesure du mouvement de et/ou de la force appliquée à l'élément de transmission dans la première zone et/ou des moyens d'actionnement.

La présente invention a également pour objet uns système comportant au moins un dispositif selon l'invention formant un capteur de pression différentiel.

Le système peut former un microphone, dans lequel le piston ou la membrane comporte une face soumise à un environnement dont on souhaite détecter les variations de pression et une face soumise à une pression de référence.

Le système peut former un haut-parleur, dans lequel le piston ou la membrane est destiné être mis en mouvement pour émettre un son.

La présente invention a également pour objet un procédé de fabrication d'un dispositif de transmission selon l'invention comportant, à partir d'un empilement comportant un substrat, une première couche sacrificielle, une couche intercalaire destinée à former les moyens d'isolation étanche, une deuxième couche sacrificielle:
a) structuration des couches de sorte à avoir accès au substrat,
b) formation d'une couche épaisse sur la deuxième couche sacrificielle et en contact avec le substrat,
c) formation d'un des bras de transmission
d) retrait au moins partielle de la deuxième couche sacrificielle,
e) report d'un capot sur la couche épaisse,
f) retournement de l'ensemble,
g) formation de l'autre bras de transmission
h) retrait au moins partielle de la première couche sacrificielle de sorte à libérer la couche.

Dans le cas où l'élément de transmission comporte au moins un arbre de transmission, celui-ci peut être formé au moins en partie lors de l'étape c) et au moins en partie lors de l'étape g).

Par exemple, l'étape c) est obtenue par structuration de la couche épaisse et l'étape g) est obtenue par structuration du substrat.

### BRÈVE DESCRIPTION DES DESSINS

La présente invention sera mieux comprise sur la base de la description qui va suivre et des dessins en annexe sur lesquels:
- la figure 1 est une vue en perspective de dessus d'un exemple de réalisation d'un dispositif selon l'invention du côté de la détection apte à détecter la différence de pression, pouvant être mis en œuvre dans un capteur de pression différentielle, et pouvant être utilisé pour former un microphone.
- la figure 2 est une vue de en perspective partielle de dessous du dispositif de la figure 1,
- la figure 3 est une vue en perspective d'un exemple de réalisation d'un dispositif selon l'invention du côté de la mesure de la différence de pression,
- la figure 4 est une vue identique à celle de la figure 3, une partie des moyens de mesure capacitifs ayant été retirés,
- la figure 5 est une vue de détail du dispositif de la figure 1,
- la figure 6 est une vue en coupe similaire à celle de la figure 5, l'élément d'isolation étanche ayant été retiré,

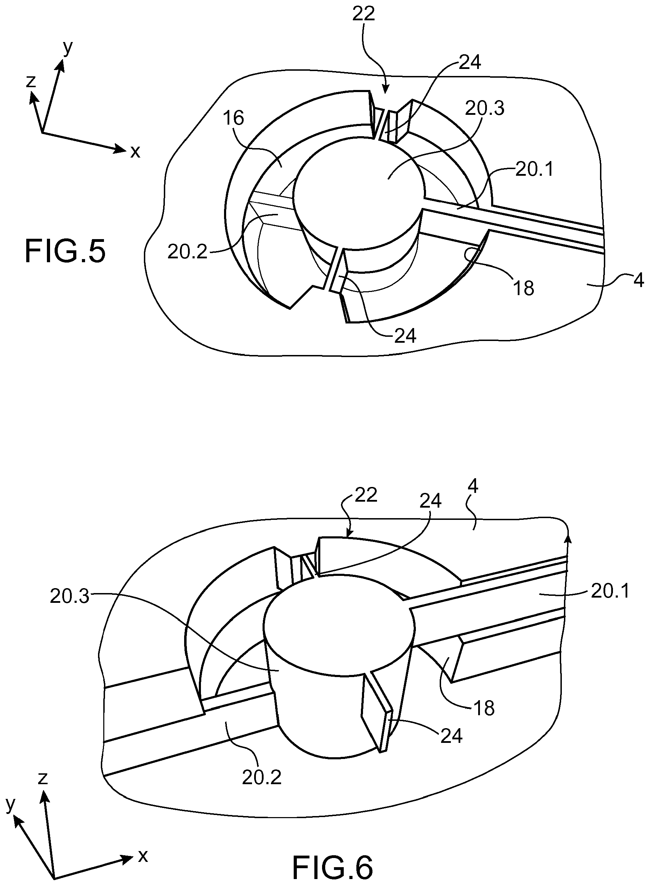

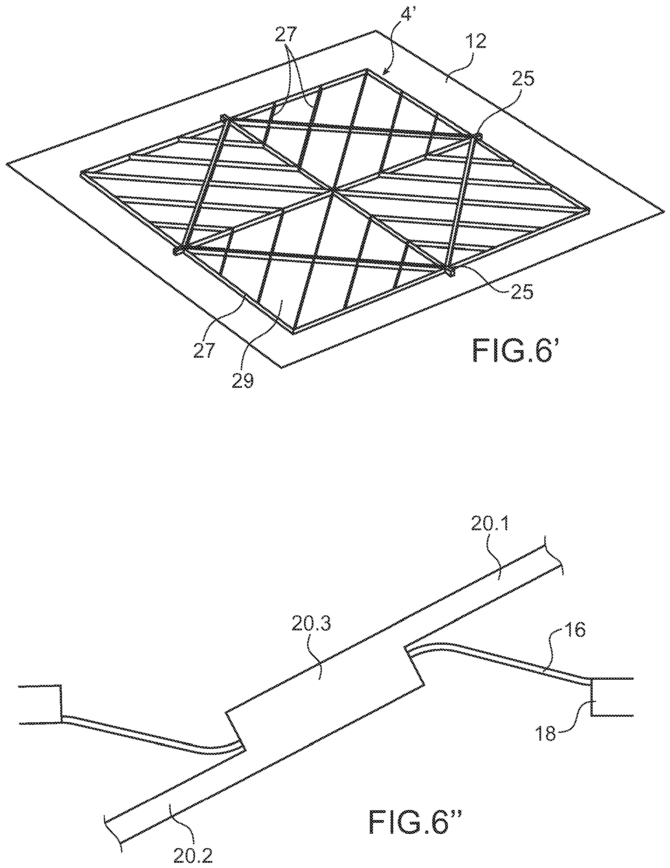

- la figure 6' est une représentation schématique d'un exemple de piston muni de moyens de rigidification,
- la figure 6" vue en coupe schématique de l'articulation pivot des figures 5 et 6 soumis à une déformation,

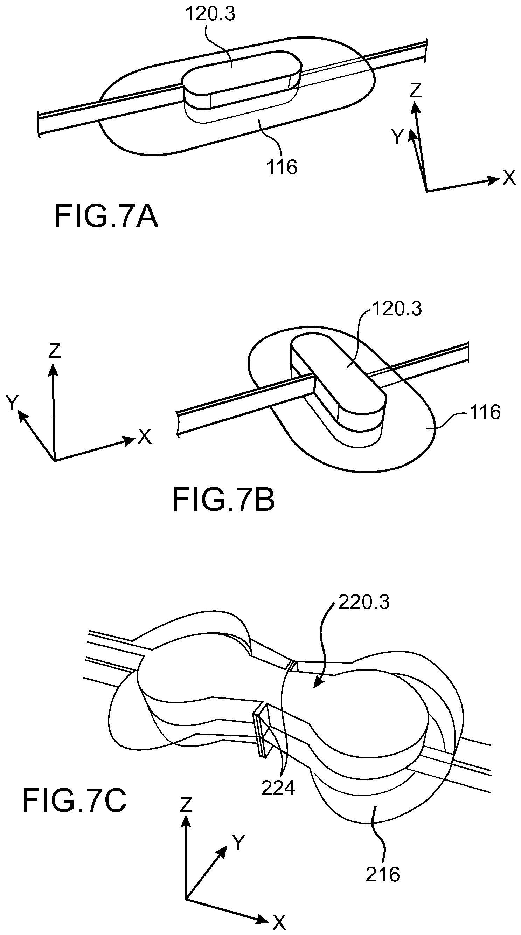

- les figures 7A à 7C sont des vues en perspective d'autres exemples de réalisation de l'articulation pivot pouvant être mise en œuvre dans le dispositif selon l'invention,

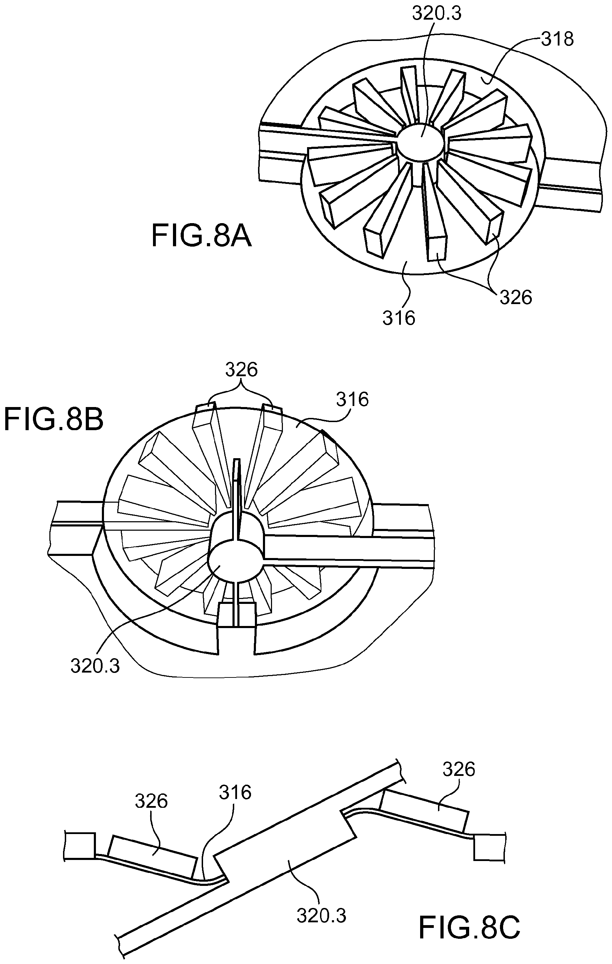

- les figures 8A et 8B sont des vues en perspective de dessus et de dessous d'un autre exemple de réalisation de l'articulation pivot et de l'élément d'isolation étanche,
- la figure 8C est une vue en coupe schématique de l'articulation pivot des figures 8A et 8B soumis à une déformation,

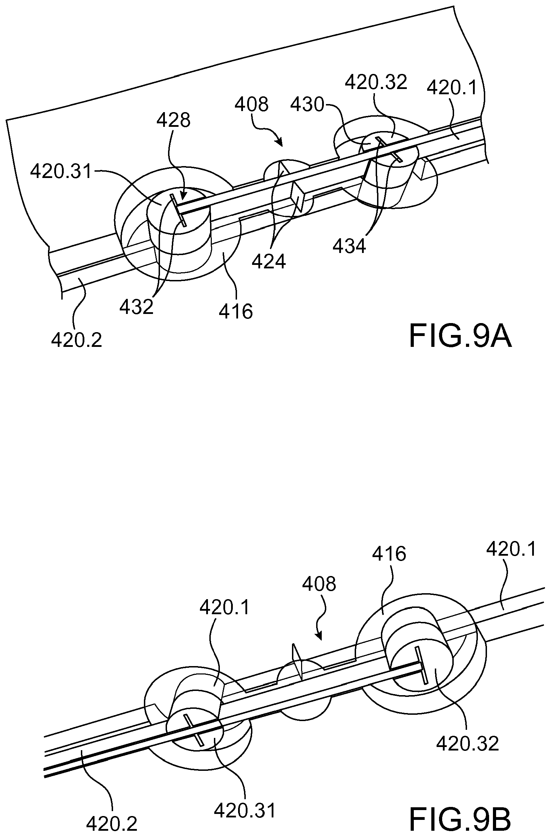

- les figures 9A et 9B sont des vues en perspective de dessus et de dessous d'un autre exemple de réalisation de l'articulation pivot et de l'élément d'isolation étanche,

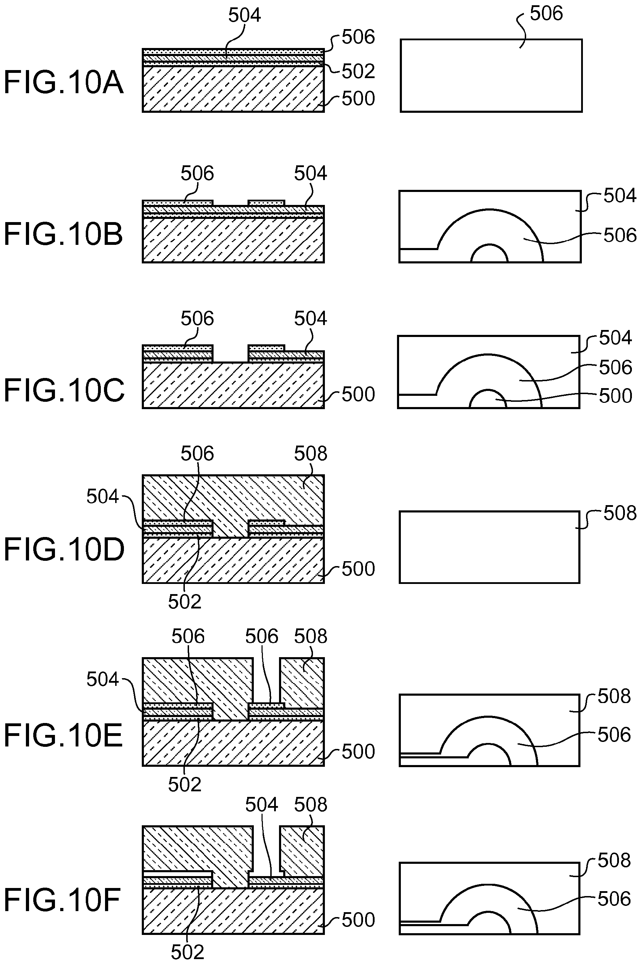

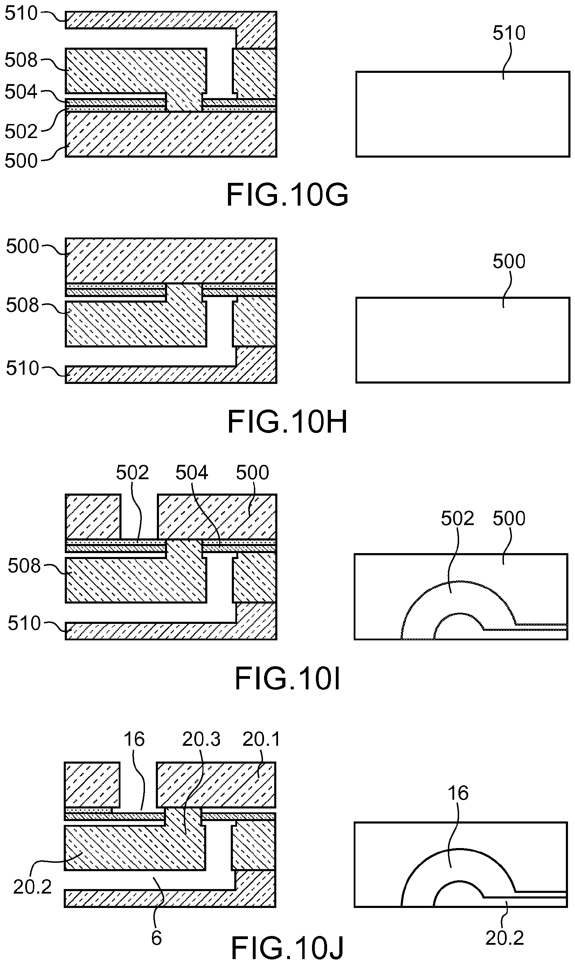

- les figures 10A à 10J sont des vues de côté et de dessus partielles d'éléments obtenus lors de différentes étapes d'un exemple de procédé de réalisation d'un dispositif selon l'invention,

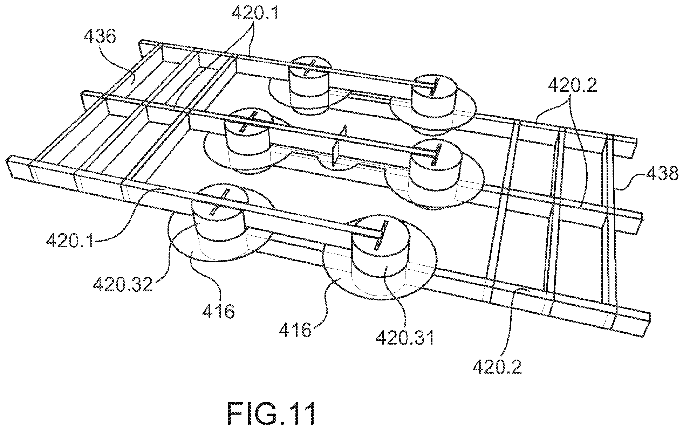

- la figure 11 est une vues en perspective d'une variante de l'exemple des figures 9A et 9B.

### EXPOSÉ DÉTAILLÉ DE MODES DE RÉALISATION PARTICULIERS

Dans la présente demande, un système microélectronique comporte un ou des dispositifs de type microsystème électromécaniques et/ou un ou des dispositifs de type nanosystème électromécanique.

Dans la description qui va suivre, le dispositif sera décrit dans une application aux microphones, mais cette application n'est pas limitative et d'autres exemples d'application seront donnés par la suite.

Les termes « supérieur » et « inférieur » et « sur » et « sous » sont utilisés pour décrire des emplacements dans le contexte des représentations des dessins et ne sont en aucun cas limitatif.

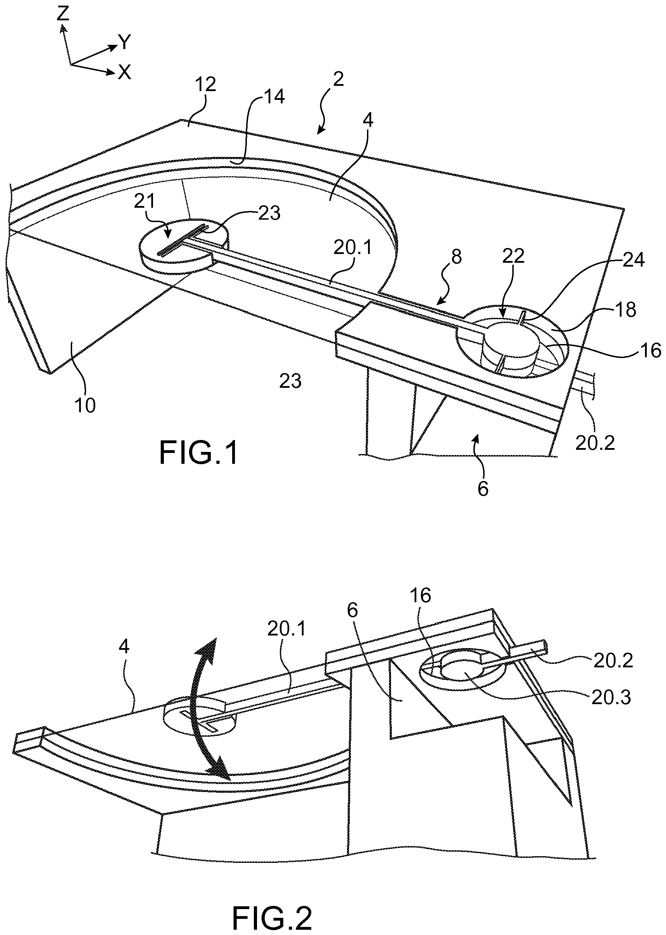

Sur les figures 1 à 6, on peut voir un exemple de réalisation d'un dispositif selon l'invention pouvant former un microphone.

La chambre de mesure 6 est définie par la plaque, le support et un élément d'isolation étanche 16 de sorte que l'intérieur de la chambre de mesure soit isolée

Le dispositif comporte un boîtier 2, une membrane de mesure 4 en contact avec l'environnement extérieur dont on veut mesurer une variation de pression acoustique, une chambre de mesure 6 isolée de l'environnement extérieur et des moyens de transmission mécanique 8 entre l'environnement extérieur et la chambre de mesure 6

Le boîtier 2 comporte par exemple un support 10 et une plaque 12 s'étendant dans un plan P et disposée sur le support 10.

La plaque 12 comporte une première ouverture 14 fermée par la membrane 4. Dans l'exemple représenté, la première ouverture 14 est de forme circulaire mais cette forme n'est en aucun cas limitative. Elle pourrait être de forme carrée, rectangulaire ou autre. La membrane 4, la plaque 12, le support 10 et un fond 13 délimitent deux volumes.

La membrane peut être soumise à une différence de pression entre les deux volumes. Le dispositif forme alors un capteur de pression différentiel statique.

On peut réaliser un capteur de pression différentielle dynamique par exemple en réalisant un trou de la membrane, de sorte qu'à basse fréquence les pressions dans les deux volumes s'équilibrent et en cas de variation à haute fréquence, les pressions dans les deux volumes n'aient pas le temps de s'équilibrer, permettant la détection de cette variation de pression haute fréquence.

Si l'un des volumes est fermé, on peut réaliser un microphone. Par exemple le volume fermé peut être réalisé avec un capot rapporté sur la plaque 12 et définissant un grand volume de référence.

La plaque 12 comporte une deuxième ouverture 18 débouchant dans la chambre de mesure. La deuxième ouverture 18 est obturée en partie par l'élément d'isolation étanche 16. L'élément d'isolation 16 est en outre déformable élastiquement de sorte à ne pas s'opposer à la rotation des moyens de transmission, mais à limiter leur déplacement dans le plan comme cela sera décrit par la suite.

Dans le cas d'un microphone et d'une chambre de mesure au vide, l'élément d'isolation étanche est configuré pour supporter une différence pression d'environ 10⁵ Pa

Les moyens de transmission comportent un élément de transmission s'étendant au repos le long d'un axe X et articulé en rotation par une articulation pivot 22 sur le boîtier 2. Dans cet exemple l'élément de transmission est rigide ou peu déformable.

L'élément de transmission 20 comporte un premier bras de transmission 20.1 disposé dans l'environnement extérieur et un deuxième bras de transmission 20.2 disposé dans la chambre de mesure. Dans cet exemple les deux bras de transmission 20.1, 20.2 sont alignés.

Dans l'exemple représenté, le premier bras de transmission 20.1 et le deuxième bras de transmission 20.2 sont reliés rigidement par une portion centrale 20.3, appelée arbre de transmission. Dans l'exemple représenté, l'arbre de transmission 20.3 a une forme cylindrique à section circulaire dont la dimension le long de l'axe Z est égale sensiblement à celle de la plaque.

Egalement dans l'exemple représenté, le premier bras de transmission 20.1 et le deuxième bras de transmission 20.2 sont disposés dans deux plans distincts, le premier bras de transmission 20.1 étant situé au-dessus de l'élément d'isolation étanche 16 et le deuxième bras de transmission étant situé au-dessous de l'élément d'isolation étanche 16.

Le bras de transmission 20.3 traverse l'élément d'isolation étanche 16.

Dans l'exemple représenté, le premier bras de transmission 20.1 se raccorde à une première zone de la face latérale de l'arbre de transmission 20.3 et le deuxième bras de transmission 20.2 se raccorde à l'arbre de transmission en une deuxième zone de sa face latérale, diamétralement opposée à la première zone.

L'extrémité libre du premier bras de transmission 20.1 est reliée à la membrane 4 par une articulation 21 transmettant le déplacement le long de la direction Z tout en autorisant la rotation autour de l'axe Y et la translation le long de l'axe X. Dans l'exemple représenté deux lames 23 parallèles à l'axe Y sont déformables en torsion.

Il pourrait être envisagé de mettre en œuvre plusieurs bras de transmission reliés chacun par une liaison à une même membrane, chaque bras de transmission serait alors articulé sur la plaque 12. Chaque bras de transmission pourrait permettre la détection du déplacement de la membrane. En récupérant les efforts à plusieurs endroits de la membrane, la réalisation de la membrane peut être facilitée. Inversement le dispositif pourrait comporter plusieurs membranes reliées à un seul bras de transmission.

Dans l'exemple représenté, la membrane 4 est déformable et est suspendue au bord de la première ouverture 14. Elle se déforme sous l'effet de la variation de pression. Le volume de référence peut être connecté à l'extérieur par un petit trou qui peut se trouver dans la membrane ou dans une autre paroi du volume de référence.

Dans un autre exemple de réalisation, la membrane pourrait être remplacée par un piston rigide 4'. Le piston serait par exemple détouré et/ou rigidifié par un ou des renforts. Par exemple, le piston pourrait avantageusement comporter une structure de rigidification d'une couche fine récoltant la différence de pression sur toute la surface. Un exemple est par exemple présenté sur la figure 6'.

Le piston est relié à la plaque 12 par des éléments de liaison 25, qui permette au piston un déplacement dans une direction hors-plan. Les éléments de liaison comportent par exemple une poutre reliée à la plaque et au piston par des lames déformables. Dans l'exemple représenté, quatre éléments de liaison 25 disposés au centre de chaque bord du piston sont mis en œuvre. L'élément de transmission n'est pas représenté. Dans cette représentation, le piston comporte une structure de rigidification 27 par exemple réalisée dans la couche servant à la réalisation du premier ou deuxième bras de transmission, et une membrane fine 29. Des butées peuvent être prévues disposées de sorte à limiter le déplacement hors-plan du piston en cas de trop forte différence de pression.

Le piston présente une rigidité élevée, ce qui limite les pertes d'énergie en déformation, tout en limitant avantageusement la masse. En effet une augmentation de la masse provoque une perte en bande passante.

Dans le cas d'un piston détouré, la structure de rigidification comprend avantageusement un rebord s'étendant dans la direction Z sur son contour extérieur de sorte à allonger le chemin de l'air du piston et réduire les fuites entre l'extérieur et le volume fermé servant de référence.

Grâce à la structure mise en œuvre la pression est collectée sur toute la surface et l'énergie perdue dans la déformation du piston est négligeable.

En outre, elle permet de réduire la masse du dispositif.

Comme cela a été décrit pour un dispositif mettant en œuvre une membrane pourrait envisager de mettre en œuvre des éléments de liaison reliant le piston à la plaque, les éléments de liaison étant articulés sur la plaque et/ou sur le piston, afin d'améliorer le mouvement de translation du piston le long de l'axe Z.

En outre, le piston peut prendre une forme quelconque permettant d'optimiser la taille du système microélectromécanique et/ou nanoélectromécanique.

Sur les figures 5 et 6, on peut voir des vues de détail de l'articulation pivot 22 des figures 1 et 2. Dans l'exemple représenté, elle comporte deux lames 24 éloignées s'étendant perpendiculairement au plan de la plaque et s'étendant chacune d'un bord de la portion centrale. Dans cet exemple, les lames sont en contact avec l'élément d'isolation étanche 16, mais ceci n'est pas limitatif.

Les lames présentent une dimension dans la direction X de sorte à se déformer en torsion autour de l'axe Y et définir avec la membrane d'étanchéité 16 l'axe de rotation de l'articulation pivot. Dans l'exemple représenté, l'axe de rotation est situé environ à l'intersection du plan de la membrane d'étanchéité 16 et du plan des lames 24. L'axe de rotation est centré sur la membrane d'étanchéité afin que l'action de la différence de pression entre les deux faces soit la même de chaque côté de l'axe de rotation.

En outre, les lames 24 présentent une dimension importante selon la direction Z, offrant ainsi une grande rigidité dans la direction hors-plan Z, ce qui limite avantageusement le déplacement hors-plan de l'élément de transmission. Ainsi la différence de pression entre l'environnement extérieur et la chambre de mesure ne tend pas à déplacer l'élément de transmission et n'influe pas sur la mesure.

Dans l'exemple représenté, les lames s'étendent entre l'élément d'isolation étanche 16 et la face supérieure de la plaque.

En outre, l'élément d'isolation étanche 16 limite les déplacements dans le plan XY.

L'élément d'isolation étanche 16 est tel qu'il se déforme sous l'effet du déplacement des bras de transmission en rotation, la raideur de l'élément d'isolation est compatible avec les moyens de détection. Dans le cas d'une détection capacitive, la déformation de la liaison comprenant les poutres 24 sollicitées en torsion et la membrane apporte, de préférence, la rigidité requise pour obtenir la bonne fréquence de résonance. Dans le cas de la transmission d'un effort, la raideur engendrée par la déformation de la liaison comprenant les poutres 24 sollicitées en torsion et la membrane est préférentiellement inférieure, voire très inférieure à celle engendrée par l'effort à transmettre, par exemple la compression d'une jauge vibrante par exemple.

Sur la figure 6", on peut voir une représentation schématique du dispositif au niveau de l'articulation pivot dans un état où les bras de transmission sont sujet à une variation de pression et sont inclinés par rapport à la plaque sous l'effet de cette différence de pression. L'élément d'isolation étanche 16 est déformé.

L'élément d'isolation étanche 16 et les lames de torsion se déforment facilement pour permettre la rotation des bras de transmission et s'opposent aux mouvements dans directions X, Y et Z au niveau de cet axe de rotation. La part d'énergie perdue lors de la transmission du mouvement utile est limitée, l'articulation présente alors un très bon rendement mécanique.

En outre, comme indiqué ci-dessus, on élimine l'effet d'un différentiel de pression entre l'environnement extérieur et la chambre de mesure.

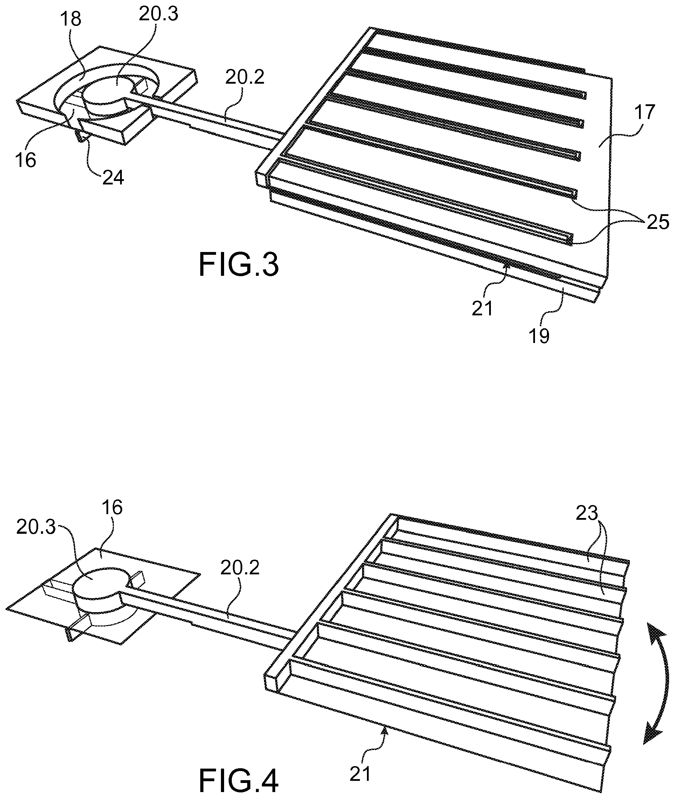

Sur les figures 3 et 4, on peut voir un exemple de moyens de mesure capacitifs à variation d'entrefer du déplacement en rotation des bras de transmission.

Dans l'exemple représenté et de manière avantageuse, les moyens de mesure capacitifs comportent une première électrode fixe 17, une deuxième électrode fixe 19 à distance de la première électrode fixe 17 et une électrode mobile 21 fixée sur l'extrémité libre du deuxième bras de transmission 20.2 et déplacée avec le bras de transmission. L'électrode mobile 21 est disposée entre la première électrode fixe 17 et la deuxième électrode fixe 19 parallèlement à celles-ci et apte à se rapprocher de l'une ou l'autre des électrodes fixes 17, 19. De tels moyens de mesure permettent une mesure différentielle. L'électrode 19 est formée dans la plaque 12.

Des moyens de mesure avec une électrode fixe et une électrode mobile ne sortent pas du cadre de la présente invention.

La première électrode fixe 17 est solidaire de la plaque dans la chambre de mesure.

Dans l'exemple représenté, l'électrode mobile 21 comporte, sur sa face supérieure, des renforts linéaires 23 parallèles à la direction X, la première électrode est conformée pour loger ces renforts 23. Elles comportent des évidements 25 logeant les renforts 23.

L'électrode mobile présente une bonne rigidité du fait des forces électrostatiques et une masse réduite, afin d'obtenir de hautes fréquences de résonance.

En mesurant la variation d'entrefer entre l'électrode mobile 21 et les première 17 et deuxième 19 électrodes fixes on peut détecter le déplacement de l'élément de transmission et ainsi déterminer la variation de pression.

Des électrodes fixes et mobiles planes sans renfort ne sortent pas du cadre de la présente invention.

En variante, les moyens de mesure capacitifs pourraient être à variation de surface en utilisant des peignes interdigités. Par exemple dans l'exemple représenté, les renforts formeraient les électrodes portées par un support mobile et les premières électrodes fixes seraient formées dans le support 17. La variation de capacité serait mesurée entre les surfaces latérales des électrodes et les surfaces latérales des premières électrodes fixes.

L'atmosphère dans la chambre de mesure est avantageusement le vide afin de réduire les phénomènes de frottement visqueux et les bruits thermiques associés.

Comme cela a été décrit pour le piston 4, l'électrode mobile pourrait être reliée à plusieurs éléments de transmission ayant des axes de rotation différents, par l'intermédiaire d'une liaison mécanique autorisant une rotation hors-plan entre le bras et l'électrode mobile. Ainsi l'électrode mobile aurait un déplacement en translation le long de l'axe Z, à condition que les éléments de transmission transmettent tous le même déplacement.

Sur les figures 7A à 7C, on peut voir des variantes de réalisation de l'arbre de transmission et de son montage dans la plaque

Sur la figure 7A, l'arbre de transmission 120.3 présente une forme allongée dont la plus grande longueur est alignée avec l'axe X. Dans l'exemple représenté, l'arbre de transmission a une section oblongue dans le plan du dispositif. L'élément d'isolation étanche 116 présente également une forme allongée le long de l'axe X. L'élément de transmission présente alors une rigidité augmentée, l'énergie perdue dans la déformation de l'élément de transmission est réduite. Il y alors moins de perte dans la transmission du mouvement d'un bras à l'autre.

Les lames de torsion assurant la liaison pivot ne sont pas représentées.

Les extrémités de l'élément d'isolation d'étanche 116 le long de l'axe X subissent une plus grande déformation hors-plan. L'élément d'isolation étanche 116 présente alors une plus grande raideur et est apte à accepter des contraintes plus fortes.

Sur la figure 7B, l'arbre de transmission 120.3 présente une forme allongée dans la direction Y, une forme oblongue dans l'exemple représenté. L'élément d'isolation étanche 116 présente alors également une forme allongée le long de l'axe Y.

De préférence, l'arbre de transmission présente une forme dépourvue de forme anguleuse pour réduire les contraintes dans l'élément d'isolation étanche. Il présente alors de préférence une forme délimitée par de contours arrondis. Néanmoins un arbre de transmission dont la section dans le plan du dispositif a une forme polygonale est envisageable particulièrement si les angles sont arrondis.

Sur la figure 7C, on peut voir un exemple d'arbre de transmission de forme allongée le long de l'axe X et réduisant les contraintes dans la membrane.

L'arbre de transmission 220.3 présente dans sa zone centrale le long de l'axe X une zone amincie dans la direction Y, les lames de torsion 224 raccordant l'arbre de transmission à la plaque 212 au niveau de la zone amincie. L'ouverture, ainsi que l'élément d'isolation étanche 216 présentent une forme homothétique de celle de l'arbre de transmission.

Sur les figures 8A à 8C, on peut voir un autre exemple de réalisation du dispositif selon l'invention dans lequel l'élément d'isolation étanche présente une raideur en flexion réduite afin de réduire la raideur angulaire de l'articulation.

Pour cela, on peut par exemple augmenter la surface de l'élément d'isolation étanche 316 afin d'augmenter la distance entre la périphérie de l'arbre de transmission et le contour de l'orifice. On peut également, alternativement ou en combinaison, réduire l'épaisseur de l'élément d'isolation étanche. Avantageusement, afin de limiter les contraintes dues à la différence de pression entre l'environnement et le chambre de mesure, des renforts 326 sont prévus sur l'une des faces au moins de l'élément d'isolation étanche 316. Par exemple les renforts 326 sont radiaux et ne gêne pas la déformation de l'élément d'isolation étanche 316. L'élément d'isolation étanche 316 peut se déformer au niveau de sa périphérie extérieure raccordée au bord de l'orifice 318 et au niveau de sa périphérie intérieure reliée au bord de l'arbre de transmission 320.3. L'élément de transmission, à l'état déformé, est représenté sur la figure 8C.

En variante les renforts pourraient être concentriques à l'arbre de transmission. En outre, les renforts pourraient être prévus sur l'une et/ou l'autre des faces de l'élément d'isolation étanche.

Sur les figures 9A et 9B, on peut voir un autre exemple de réalisation du dispositif selon l'invention comportant deux arbres de transmission mobile en translation.

Le dispositif comporte un élément de transmission 408 comprenant deux bras de transmission 420.1, 420.2 reliés par deux arbres de transmission 420.31 et 420.32.

Les bras de transmission sont reliés aux arbres de transmission de sorte que les arbres de transmission puissent se déplacer en translation dans la direction de l'axe Z. Cet arrangement a pour avantage de réduire les contraintes subies par l'élément d'isolation étanche 416.

L'arbre de transmission 420.31 est connecté à une extrémité libre du bras de transmission 420.1 par une première articulation 428 et l'arbre de transmission 420.32 est connecté au bras de transmission 420.1 dans une zone intermédiaire de celui-ci par une deuxième articulation 430.

Dans l'exemple représenté, les première et deuxième articulations 428, 430 comportent deux lames 432, 434 contenues dans le plan du dispositif et aptes à se déformer en torsion et en flexion dans le plan par flexion, ainsi les arbres de transmission peuvent avoir un mouvement de translation le long de l'axe Z, et les bras de transmission peuvent avoir un mouvement de rotation autour d'un axe parallèle à l'axe Y.

Le deuxième bras de transmission 420.2 est relié aux arbres de transmission 420.31, 420.32, comme les premier bras de transmission 420.1.

Comme on peut le voir sur la figure 9B, l'arbre de transmission 420.32 est reliée au deuxième bras de transmission dans une zone intermédiaire de celui-ci et l'arbre de transmission 420.31 est relié à l'extrémité libre du deuxième bras de transmission.

En outre, le premier bras de transmission est reliée à la plaque par deux lames 424 déformables en torsion est définissant l'axe de rotation. Dans l'exemple représenté et de manière avantageuse, les lames 424 sont situées au milieu entre les deux arbres de transmission afin que la pression extérieure n'engendre pas une rotation qui s'additionnerait au signal à mesurer.

Les lames 424 s'opposent aux efforts dus à la différence de pression d'un côté à l'autre de la plaque, et réduisent considérablement leurs effets pour les rendre négligeables.

L'élément de transmission « déformable » ainsi formé permet de transmettre le mouvement d'un côté à l'autre de la plaque.

Lors d'une transmission d'un mouvement d'un côté à l'autre, l'un des arbres de transmission est déplacé dans un sens dans la direction Z et l'autre arbre de transmission est déplacé dans un sens opposé dans la direction Z. La translation globale est ainsi annulée.

Des renforts radiaux et/ou des renforts concentriques sont envisageables.

Il sera compris que le dispositif des figures 9A et 9B pourrait comporter plus de deux arbres de transmission, ceux-ci ne seraient pas nécessairement alignés. Les arbres de transmission 420.1 d'une part et 420.2 d'autre part pourraient avantageusement être reliés entre eux par des bras transversaux 436, 438 respectivement comme cela est représenté sur la figure 11

Le dispositif de transmission selon l'invention est donc particulièrement adapté à la réalisation d'un microphone. Comme cela est représenté sur les figures 1 à 4 une membrane, en contact avec l'environnement extérieur, capte les variations de pression acoustique et les moyens de détection, avantageusement capacitifs et disposés dans une atmosphère contrôlée avantageusement dans le vide, mesurent ces variations de pression qui sont ensuite traitées. Les bruits et les amortissements intrinsèques aux déplacements d'air entre les électrodes sont alors réduits. En variante, les moyens de détection pourrait être réalisés par des poutres résonantes, type corde de guitare, disposées avantageusement dans le vide.

Les moyens de mesure capacitifs mesurent le déplacement du piston dans le cadre d'un microphone à boucle ouverte. Ils peuvent aussi permettre d'exercer une force à l'élément de transmission en générant une force électrostatique entre les électrodes. Cette force peut permettre d'adopter le comportement d'un ressort à raideur négative. Ce comportement permet d'ajuster la fréquence de résonance du microphone en fonctionnement. Ainsi, en cas de fort signal, le microphone pourra présenter une raideur plus forte (moins de raideur négative) afin de ne pas saturer, et inversement en cas de faible signal d'entrée.

On peut aussi utiliser cette force électrostatique pour asservir la structure grâce à une rétroaction. Le microphone, placé ainsi au cœur d'une boucle fermée, pourrait présenter une plus forte bande passante et une gamme dynamique améliorée dans le cadre d'un microphone haute performance.

Le dispositif selon l'invention peut également être mis en œuvre dans un haut-parleur. L'élément de transmission relie le piston qui est placé entre l'extérieur et un volume fermé à une pression de référence, et une électrode mobile d'un actionneur capacitif. Sa disposition dans le vide assurerait un actionnement sans bruit acoustique. Le piston impose alors une surpression/dépression. Le dispositif selon l'invention peut également être utilisé pour remplir la fonction de « C-MUT (capacitive micro-usined transducer) », utilisée notamment pour les échographies qui assure l'émission puis la réception d'ultra-sons. Grâce à l'invention, l'effet de la pression atmosphérique est réduit grâce à l'articulation pivot de l'élément de transmission. Au contraire, dans les C-MUT de l'état de la technique, une membrane sépare l'air du vide, la membrane étant mise en mouvement par une contre-électrode. L'entrefer doit alors prendre en compte l'amplitude considérable de la pression atmosphérique qui déforme plus ou moins la membrane. En conséquence, une haute tension polarise la membrane pour l'attirer et la placer au même entrefer quelle que soit la pression extérieure. La présence invention permet de s'affranchir de l'application de ces très hautes tensions.

Le dispositif selon l'invention peut également être mis en œuvre dans un capteur utilisé dans un milieu agressif, par exemple dans un liquide oxydant ou provoquant des courts-circuits, dans ces cas la mise en œuvre de moyens capacitifs est exclue. Grâce à la présente invention, les moyens de détection étant disposés dans la chambre de mesure, ils sont protégés, par exemple ils sont protégés de la vapeur d'eau. Le dispositif selon l'invention peut alors par exemple être mis en œuvre dans une fonction de débitmètre (compteur d'eau, encrassage de filtres à particules)

Il sera compris que tout moyen de mesure peut être mis en œuvre dans la chambre étanche tel que des moyens piézorésistifs ou piézoélectriques sous forme de jauge de contrainte.

En outre, on pourrait envisager que la plaque ne comporte que l'ouverture 18 pour permettre le passage de l'élément de transmission entre les deux zones isolées de manière étanche.

Un exemple de procédé de réalisation d'un dispositif des figures 1 à 6 va maintenant être décrit en relation avec les figures 10A à 10J.

On réalise une première couche sacrificielle 502, par exemple en SiO₂, sur un substrat 500, par exemple un substrat en silicium standard de 750µm d'épaisseur. La première couche sacrificielle a par exemple une épaisseur comprise entre quelques centaines de nanomètres et quelques micromètres. Une couche de quelques centaines de nanomètres à quelques µm de silicium poly-cristallin 504 est ensuite formée, par exemple par dépôt chimique en phase vapeur ou CVD (chemical vapor déposition en terminologie anglo-saxonne), sur la première couche 502. La couche 504 servira à réaliser l'élément d'isolation étanche 16.

En variante, un substrat silicium sur isolant ou SOI pourrait être utilisé directement, la couche de silicium monocristallin servant à la réalisation de l'élément d'isolation étanche 16.

Ensuite une seconde couche sacrificielle 506 est réalisée sur la couche 504. La seconde couche sacrificielle est par exemple réalisée dans le même matériau que la première couche sacrificielle 502.

L'élément ainsi formé est représenté sur la figure 10A.

Lors d'une étape suivante, la seconde couche sacrificielle est structurée, par exemple par photo-lithogravure, par exemple par gravure sèche, par gravure ionique réactive ou RIE (Reactive Ionic Etching en terminologie anglo-saxonne). Cette structuration a pour but de ne laisser que les zones correspondant aux parties en mouvement, à l'élément d'isolation étanche et à l'élément de transmission.

L'élément ainsi formé est représenté sur la figure 10B.

Lors d'une étape suivante, on structure les couches 502 et 504 pour atteindre le substrat 500 au niveau de l'emplacement du bras de transmission. Cette structuration est réalisée par exemple par photo-lithogravure, par exemple gravure sèche ou RIE.

L'élément ainsi formé est représenté sur la figure 10C.

Lors d'une étape suivante, on réalise une couche de silicium 508 par exemple par épitaxie, de quelques microns à quelques dizaines de microns sur les couches 502, 504, 506 structurées Une étape de polissage mécano-chimique peut avoir lieu pour réduire la topologie de surface. La couche 508 est destinée à la réalisation du MEMS.

L'élément ainsi formé est représenté sur la figure 10D.

Lors d'une étape suivante, la couche 508 est structurée, par exemple par gravure profonde ou DRIE (Deep Reactive Ionic Etching en terminologie anglo-saxonne). Lors de cette gravure sont formés l'un des bras de transmission et l'arbre de transmission.

L'élément ainsi formé est représenté sur la figure 10E.

Lors d'une étape suivante, on réalise une première libération permettant de dégager une partie de la liaison. De manière avantageuse, l'élément de la figure 10E est immergé dans de l'acide fluorhydrique (HF) en phase liquide ou vapeur pendant un temps maitrisé.

L'élément ainsi formé est représenté sur la figure 10F.

Lors d'une étape suivante, un capot 510 est rapporté sur l'élément de la figure 10F. Ce capot comporte une cavité 512 destinée à délimiter la chambre de mesure.

Le volume de la cavité 512 est tel qui permet un débattement du deuxième bras de transmission. En outre il est choisi suffisamment important, en effet plus le volume est important, meilleur sera le vide. Le capot est par exemple réalisé par usinage d'un substrat de silicium standard. Le capot est rapporté sur l'élément de la figure 10F, par exemple par collage direct (Si-Si / SiO₂-SiO₂ / Si-SiO₂), ou scellement eutectique (Au-Si, Al-Ge).

L'élément ainsi formé est représenté sur la figure 10G.

L'élément de la figure 10G est ensuite retourné.

Lors d'une étape suivante, le substrat 500 est aminci, par exemple par gravure DRIE et/ou broyage (Grinding en terminologie anglo-saxonne) et/ou polissage mécanochimique. On obtient ainsi l'épaisseur de la seconde couche servant à réaliser le second bras, typiquement quelques microns à quelques dizaines de microns

L'élément ainsi formé est représenté sur la figure 10H.

Lors d'une étape suivante, le substrat 500 aminci est structuré, par exemple par gravure, par exemple gravure DRIE, pour former l'autre bras de transmission L'élément ainsi formé est représenté sur la figure 10I.

Lors d'une autre étape, le dispositif de transmission est libéré, par exemple par immersion dans de l'acide fluorhydrique (HF) en phase liquide ou vapeur pendant un temps maitrisé.

Ce procédé de fabrication est compatible avec la fabrication des dispositifs MEMS/NEMS.

Comme cela a été décrit ci-dessus, le piston 4 et/ou l'électrode mobile peuvent être réalisés simultanément.

## Revendications

1. Dispositif de transmission pour système microélectromécanique, ledit dispositif de transmission étant apte à transmettre un mouvement et une force entre une première zone et une deuxième zone isolées l'une de l'autre de manière étanche, ledit dispositif de transmission comportant un support s'étendant dans un plan, un élément de transmission (8, 408) mobile en rotation par rapport au support au moyen d'une articulation pivot (22) d'axe de rotation parallèle au plan du support, une ouverture (18) dans le support **caractérisé en ce que** ladite ouverture (8) est traversée par l'élément de transmission (8, 408) et au niveau de laquelle est disposée l'articulation pivot (22), l'élément de transmission comportant au moins un premier bras de transmission (20.1, 420.1) d'un côté du plan du support dans une des première et deuxième zones et un deuxième bras de transmission (20.2, 420.2) de l'autre côté du plan du support dans l'autre desdites première et deuxième zones, et des moyens d'isolation étanche (16) disposés dans l'ouverture (18), tels qu'ils isolent de manière étanche la première zone de la deuxième zone et qu'ils permettent le mouvement de rotation de l'élément de transmission (8, 408).

2. Dispositif de transmission selon la revendication 1, dans lequel les moyens d'isolation étanche (16) comportent une membrane déformable élastiquement et tendue entre un rebord de l'ouverture et l'élément de transmission, les moyens d'isolation étanche comportant avantageusement des renforts mécaniques (326) sur au moins une des faces de la membrane.

3. Dispositif de transmission selon la revendication 1 ou 2, dans lequel l'articulation pivot (26) comporte une lame ou plusieurs lames alignées (24) s'étendant entre l'élément de transmission (8) et un bord de l'ouverture (18) et apte à se déformer en torsion, la ou les lames (24) présentant avantageusement une dimension selon une direction orthogonale au plan du support telle qu'elle(s) offre(nt) une rigidité dans la direction hors-plan limitant les mouvements hors-plan de l'élément de transmission (8).

4. Dispositif de transmission selon l'une des revendications 1 à 3, dans lequel l'élément de transmission (8) comporte au moins un arbre de transmission (20.3) connectant les premier (20.2) et deuxième (20.3) bras de transmission, ledit arbre de transmission (20.3) s'étendant dans une direction orthogonale au plan du support de part et d'autre des moyens d'isolation étanche (16).

5. Dispositif de transmission selon la revendication 4 en combinaison avec la revendication 3, dans lequel la ou les lames (24) sont connectées à l'arbre de transmission (20.3) et l'ensemble formé par l'arbre de transmission (20.3) et les premier (20.1) et deuxième (20.2) bras de transmission est un ensemble rigide.

6. Dispositif de transmission selon la revendication 4, dans lequel l'élément de transmission (408) comporte plusieurs arbres de transmission (420.31, 420.32) aptes à se déplacer en translation le long d'une direction orthogonale au plan du support.

7. Dispositif de transmission selon la revendication 6, dans lequel chaque premier (420.1) et deuxième (420.2) bras de transmission est articulé sur chaque arbre de transmission (420.31, 420.32) par une articulation permettant une rotation et une translation (428, 430) et dans lequel la ou les lames (424) sont connectées mécaniquement à l'un des premier (420.1) et deuxième (420.2) bras de transmission, pour chaque arbre de transmission, l'articulation permettant une rotation et une translation dudit arbre comportant avantageusement une ou plusieurs lames de couplage (432, 434).

8. Dispositif de transmission selon l'une des revendications 1 à 7, dans lequel l'une au moins des première et deuxième zones forment une chambre sous atmosphère contrôlée.

9. Dispositif de transmission selon l'une des revendications 1 à 8, comportant un élément mobile vis-à-vis du support tel qu'un piston (4) ou une membrane apte à appliquer un mouvement et une force à l'élément de transmission dans la première zone.

10. Dispositif de transmission selon l'une des revendications 1 à 9, comportant, dans la deuxième zone, des moyens de mesure du mouvement de et/ou de la force appliquée à l'élément de transmission dans la première zone et/ou des moyens d'actionnement, et comportant avantageusement, dans la deuxième zone, une électrode solidaire (21) de l'élément de transmission et au moins une contre-électrode (19, 20) formant des moyens de mesure du mouvement de et/ou de la force appliquée à l'élément de transmission dans la première zone et/ou des moyens d'actionnement.

11. Système comportant au moins un dispositif selon les revendications 9 ou 10 formant un capteur de pression différentiel.

12. Système selon la revendication 11 en combinaison avec la revendication 9 formant un microphone, dans lequel le piston ou la membrane comporte une face soumise à un environnement dont on souhaite détecter les variations de pression et une face soumise à une pression de référence.

13. Système comportant un dispositif selon les revendications 10 en combinaison avec la revendication 9, formant un haut-parleur, dans lequel le piston ou la membrane est destiné être mis en mouvement pour émettre un son.

14. Procédé de fabrication d'un dispositif de transmission selon l'une des revendications 1 à 10, comportant, à partir d'un empilement comportant un substrat, une première couche sacrificielle, une couche intercalaire destinée à former les moyens d'isolation étanche, une deuxième couche sacrificielle:
a) structuration des couches de sorte à avoir accès au substrat,
b) formation d'une couche épaisse sur la deuxième couche sacrificielle et en contact avec le substrat,
c) formation d'un des bras de transmission
d) retrait au moins partielle de la deuxième couche sacrificielle,
e) report d'un capot sur la couche épaisse,
f) retournement de l'ensemble,
g) formation de l'autre bras de transmission
h) retrait au moins partielle de la première couche sacrificielle de sorte à libérer la couche.

15. Procédé selon la revendication 14, l'élément de transmission (8) comportant en outre au moins un arbre de transmission, celui-ci étant formé au moins en partie lors de l'étape c) et au moins en partie lors de l'étape g), et/ou dans lequel l'étape c) est obtenue par structuration de la couche épaisse et l'étape g) est obtenue par structuration du substrat.

## Patentansprüche

1. Übertragungsvorrichtung für ein mikroelektromechanisches System, wobei die Übertragungsvorrichtung imstande ist, eine Bewegung und eine Kraft zwischen einer voneinander in dichter Form isolierten ersten Zone und zweiten Zone zu übertragen, wobei die Übertragungsvorrichtung eine Stütze, die sich in einer Ebene erstreckt, ein in Bezug auf die Stütze anhand eines Schwenkgelenks (22) einer Drehachse parallel zur Stützebene drehbewegliches Übertragungselement (8, 408), eine Öffnung (18) in der Stütze beinhaltet, **dadurch gekennzeichnet, dass** die Öffnung (8) durch das Übertragungselement (8, 408) durchquert wird und in deren Bereich das Schwenkgelenk (22) angeordnet ist, wobei das Übertragungselement mindestens einen ersten Übertragungsarm (20.1, 420.1) auf einer Seite der Ebene der Stütze in einer der ersten und zweiten Zone, und einen zweiten Übertragungsarm (20.2, 420.2) auf der anderen Seite der Ebene der Stütze in der anderen der ersten und zweiten Zone beinhaltet, und dichte Isoliermittel (16), die in der Öffnung (18) angeordnet sind, sodass sie die erste Zone in dichter Form von der zweiten Zone isolieren, und sie die Drehbewegung des Übertragungselements (8, 408) erlauben.

2. Übertragungsvorrichtung nach Anspruch 1, wobei die dichten Isoliermittel (16) eine elastisch verformbare, und zwischen einem Rand der Öffnung und dem Übertragungselement gespannte Membran beinhalten, wobei die dichten Isoliermittel vorteilhafterweise mechanische Verstärkungen (326) auf mindestens einer der Seiten der Membran beinhalten.

3. Übertragungsvorrichtung nach Anspruch 1 oder 2, wobei das Schwenkgelenk (26) eine Lamelle oder mehrere ausgerichtete Lamellen (24) beinhaltet, die sich zwischen dem Übertragungselement (8) und einem Rand der Öffnung (18) erstrecken und in der Lage sind, sich in Torsion zu verformen, wobei die Lamelle oder Lamellen (24) vorteilhafterweise eine Abmessung in einer Richtung senkrecht zur Ebene der Stütze derart aufweisen, dass sie eine Steifigkeit in der Richtung außerhalb der Ebene anbietet (-en), die die Bewegungen außerhalb der Ebene des Übertragungselements (8) begrenzt.

4. Übertragungsvorrichtung nach einem der Ansprüche 1 bis 3, wobei das Übertragungselement (8) mindestens eine Übertragungswelle (20.3) beinhaltet, die den ersten (20.2) und zweiten (20.3) Übertragungsarm verbindet, wobei sich die Übertragungswelle (20.3) in einer Richtung senkrecht zur Ebene der Stütze beiderseits der dichten Isoliermittel (16) erstreckt.

5. Übertragungsvorrichtung nach Anspruch 4 in Kombination mit dem Anspruch 3, wobei die Lamelle oder Lamellen (24) mit der Übertragungswelle (20.3) verbunden sind, und die von der Übertragungswelle (20.3) und dem ersten (20.1) und zweiten (20.2) Übertragungsarm gebildete Einheit eine starre Einheit ist.

6. Übertragungsvorrichtung nach Anspruch 4, wobei das Übertragungselement (408) mehrere Übertragungswellen (420.31, 420.32) beinhaltet, die imstande sind, sich translatorisch entlang einer Richtung senkrecht zur Ebene der Stütze zu bewegen.

7. Übertragungsvorrichtung nach Anspruch 6, wobei jeder erste (420.1) und zweite (420.2) Übertragungsarm an jeder Übertragungswelle (420.31, 420.32) durch ein Gelenk angelenkt ist, das eine Drehung und eine Translation (428, 430) ermöglicht, und wobei die Lamelle oder Lamellen (424) mechanisch mit einem vom ersten (420.1) und zweiten (420.2) Übertragungsarm verbunden sind, wobei das Gelenk für jede Übertragungswelle eine Drehung und eine Translation der Welle ermöglicht, die vorteilhafterweise eine oder mehrere Kopplungslamellen (432, 434) beinhaltet.

8. Übertragungsvorrichtung nach einem der Ansprüche 1 bis 7, wobei mindestens eine der ersten und zweiten Zone eine Kammer unter kontrollierter Atmosphäre bildet.

9. Übertragungsvorrichtung nach einem der Ansprüche 1 bis 8, die ein bewegliches Element gegenüber der Stütze, wie einen Kolben (4) oder eine Membran beinhaltet, der/die imstande ist, eine Bewegung und eine Kraft auf das Übertragungselement in der ersten Zone anzulegen.

10. Übertragungsvorrichtung nach einem der Ansprüche 1 bis 9, die in der zweiten Zone Mittel zum Messen der Bewegung und/oder der Kraft, die auf das Übertragungselement in der ersten Zone angelegt wird, und/oder Betätigungsmittel beinhaltet, und vorteilhafterweise in der zweiten Zone eine mit dem Übertragungselement fest verbundene Elektrode (21) und mindestens eine Gegenelektrode (19, 20) beinhaltet, die Mittel zum Messen der Bewegung und/oder der Kraft, die auf das Übertragungselement in der ersten Zone angelegt wird, und/oder Betätigungsmittel bilden.

11. System, das mindestens eine Vorrichtung nach den Ansprüchen 9 oder 10 beinhaltet, die einen Differenzdrucktransmitter bildet.

12. System nach Anspruch 11 in Kombination mit dem Anspruch 9, ein Mikrofon bildend, wobei der Kolben oder die Membran eine Seite beinhaltet, die einer Umgebung ausgesetzt ist, deren Druckvariationen man erkennen möchte, und eine Seite, die einem Referenzdruck ausgesetzt ist.

13. System, das eine Vorrichtung nach den Ansprüchen 10 in Verbindung mit dem Anspruch 9 beinhaltet, einen Lautsprecher bildend, wobei der Kolben oder die Membran dazu bestimmt ist, in Bewegung versetzt zu werden, um einen Ton auszugeben.

14. Verfahren zur Herstellung einer Übertragungsvorrichtung nach einem der Ansprüche 1 bis 10, die aus einer Stapelung, die ein Substrat, eine erste Opferschicht, eine Zwischenschicht, die dazu bestimmt ist, die dichten Isoliermittel zu bilden, eine zweite Opferschicht beinhaltet:
a) Strukturieren der Schichten, um einen Zugriff auf das Substrat aufzuweisen,
b) Bilden einer dicken Schicht auf der zweiten Opferschicht und in Kontakt mit dem Substrat,
c) Bilden eines der Übertragungsarme,
d) mindestens teilweise Entfernen der zweiten Opferschicht,
e) Übertragen einer Abdeckung auf die dicke Schicht,
f) Umdrehen der Einheit,
g) Bilden des anderen Übertragungsarmes,
h) mindestens teilweise Entfernen der ersten Opferschicht, um die Schicht freizugeben.

15. Verfahren nach Anspruch 14, wobei das Übertragungselement (8) weiter mindestens eine Übertragungswelle beinhaltet, wobei diese mindestens teilweise im Schritt c) und mindestens teilweise im Schritt g) gebildet wird, und/oder wobei der Schritt c) durch Strukturieren der dicken Schicht erhalten wird, und der Schritt g) durch Strukturieren des Substrats erhalten wird.

## Claims

1. A transmission device for a microelectromechanical system, said transmission device being able to transmit a movement and a force between a first zone and a second zone sealingly insulated from each other, said transmission device comprising a support extending in a plane, a transmission element (8, 408) rotatably movable with respect to the support by means of a pivot hinge (22) with an axis of rotation parallel to the support plane, an aperture (18) in the support **characterised in that** said aperture (19) is passed through by the transmission element (8, 408) and at which the pivot hinge (22) is disposed, the transmission element comprising at least one first transmission arm (20.1, 420.1) on one side of the support plane in one of the first and second zones and a second transmission arm (20.2, 420.2) on the other side of the support plane in the other of said first and second zones, and sealed insulation means (16) disposed in the aperture (18), such that they sealingly insulate the first zone from the second zone and they allow the rotational movement of the transmission element (8, 408).

2. The transmission device according to claim 1, wherein the sealed insulation means (16) comprise an elastically deformable membrane which is tensioned between a rim of the aperture and the transmission element, the sealed insulation means advantageously comprising mechanical reinforcements (326) on at least one of the faces of the membrane.

3. The transmission device according to one of claim 1 or 2, wherein the pivot hinge (26) comprises one blade or several aligned blades (24) extending between the transmission element (8) and an edge of the aperture (18) and able to be torsionally deformed, the blade(s) (24) advantageously having a dimension along a direction orthogonal to the support plane such that it/they offer(s) a rigidity in the off-plane direction limiting off-plane movements of the transmission element (8).

4. The transmission device according to one of claims 1 to 3, wherein the transmission element (8) comprises at least one transmission shaft (20.3) connecting the first (20.2) and second (20.3) transmission arms, said transmission shaft (20.3) extending in a direction orthogonal to the support plane on either side of the sealed insulation means (16).

5. The transmission device according to claim 4 in combination with claims 3, wherein the blade(s) (24) is (are) connected to the transmission shaft (20.3) and the assembly formed by the transmission shaft (20.3) and the first (20.1) and second (20.2) transmission arms is a rigid assembly.

6. The transmission device according to claim 4, wherein the transmission element (408) comprises several transmission shafts (420.31, 420.32) able to be translationally moved along a direction orthogonal to the support plane.

7. The transmission device according to claim 6, wherein each of the first (420.1) and second (420.2) transmission arms is hinged to each transmission shaft (420.31, 420.32) by a hinge allowing a rotation and a translation (428, 430) and in which the blade(s) (424) is (are) mechanically connected to one of the first (420.1) and second (420.2) transmission arms, for each transmission shaft, the hinge allowing a rotation and a translation of said shaft advantageously comprising one or more coupling blades (432, 434).

8. The transmission device according to one of claims 1 to 7, wherein at least one of the first and second zones form a controlled atmosphere chamber.

9. The transmission device according to one of claims 1 to 8, comprising an element movable relative to the support such as a piston (4) or a membrane able to apply a movement and a force to the transmission element in the first zone.

10. The transmission device according to one of claims 1 to 9, comprising, in the second zone, means for measuring the movement of and/or the force applied to the transmission element in the first zone and/or actuation means, and advantageously comprising, in the second zone, an electrode (21) secured to the transmission element and at least one counter-electrode (19, 20) forming means for measuring the movement of and/or the force applied to the transmission element in the first zone and/or actuation means.

11. A system comprising at least one device according to claims 9 or 10 forming a differential pressure sensor.

12. The system according to claim 11 in combination with claim 9 forming a microphone, wherein the piston or the membrane comprises a face subjected to an environment the pressure variations of which are desired to be detected and a face subjected to a reference pressure.

13. A system comprising a device according to claims 10 in combination with claim 9, forming a loudspeaker, wherein the piston or membrane is to be moved to emit a sound.

14. A method for manufacturing a transmission device according to one of claims 1 to 10, comprising, from a stack comprising a substrate, a first sacrificial layer, a sandwich layer for forming the sealed insulation means, a second sacrificial layer:
a) structuring the layers so as to have access to the substrate,
b) forming a thick layer on the second sacrificial layer and in contact with the substrate,
c) forming one of the transmission arms,
d) at least partially removing the second sacrificial layer,
e) bonding a cap on the thick layer,
f) turning over the assembly,
g) forming the other transmission arm,
h) at least partially removing the first sacrificial layer so as to release the layer.

15. The method according to claim 14, the transmission element (8) further comprising at least one transmission shaft, it being formed at least partly during step c) and at least partly during step g) and/or wherein step c) is achieved by structuring the thick layer and step g) is achieved by structuring the substrate.
